Europäisches Patentamt

European Patent Office

Office européen des brevets

(11) Publication number: **0 668 613 A1**

## EUROPEAN PATENT APPLICATION
published in accordance with Art. 158(3) EPC

(21) Application number: **94928219.8**

(22) Date of filing: **02.09.94**

(86) International application number:
**PCT/BY94/00001**

(87) International publication number:
**WO 95/07546 (16.03.95 95/12)**

(51) Int. Cl.6: **H01L 21/66**

(30) Priority: **09.09.93 BY 6420193**

(43) Date of publication of application:
**23.08.95 Bulletin 95/34**

(84) Designated Contracting States:
**DE**

(71) Applicant: **SOVIET-GERMAN JOINT VENTURE "MAMT"**
**ul. Olesheva, 14**
**Minsk 220090 (BY)**

(72) Inventor: **LITVINOV, Valentin Vladimirovich**
**ul. Lynkova, 29-1-25**
**Minsk, 220128 (BY)**
Inventor: **POKATILO, Jury Mifodievich**
**pr. Pavdy, 14-164**
**Minsk, 220116 (BY)**
Inventor: **URINEV, Valery Ivanovich**
**ul. R. Luxemburg, 111a-32**
**Minsk, 220036 (BY)**

(74) Representative: **Symes, Christopher A. et al**
**FORRESTER & BOEHMERT**
**Franz-Joseph-Strasse 38**
**D-80801 München (DE)**

(54) **METHOD OF DETERMINING THE CONCENTRATION OF OXYGEN IN SILICON CRYSTALS.**

(57) The proposed method of determining the oxygen content of silicon crystals relates to electronics and can be used for sorting silicon crystals according to their oxygen content and also for optimizing crystal production techniques based on the Chokhralski method. In essence, the method involves: generation of three alternate beams of radiation of different wavelengths, one of which lies at the absorption maximum of interstitial oxygen at 5.81 $\mu$m, the other two being outside its limits in a region of linear spectral dependence of the background optical density of the crystal; using monochromatic radiation from a three-wavelength CO laser with a modulating disk incorporated into the resonator, the said disk alternately switching one of the beans on and off; measuring two ratios of radiation transmission coefficients of the crystal, while the oxygen concentration being sought is determined with the aid of an established function.

EP 0 668 613 A1

## Field

The invention relates to electronics and can be used for control of content and distribution of oxygen in silicon ingots.

## Prior Art

There is known a conventional optic method of determining the concentration of oxygen in silicon (Certificate of Authorship of the USSR No. 1447201, cl. H O1L 21/66, 1986), based on the determining the coefficient of absorption at the absorption maximum of 5.8 $\mu$m.

The disadvantage of this conventional method is the necessity of separating the ingots into wafers and optically polishing their surfaces.

There is also known a method of controlling oxygen distribution in silicon ingots along the aids of their growth (Certificate of Authorship of the USSR No. 1669340, cl. H O1L 21/66, 1991) involving irradiating an unpolished side of the ingot under examination with three beams of IR-radiation, two of which beams having different wavelengths outside the absorption band and the third beam having a wavelength of 5.81 $\mu$m (1720cm$^{-1}$), corresponding to a range of interstitial oxygen absorption. Detection of the incident and transmitted radiation intensities and subsequent determination of the transmission coefficients, enables the oxygen concentration to be determined by reference to known values.

However, the application of the above method for control of industrial ingots, being products grown according to the Czochralski method and having an oxygen concentration of more than 2 x 10$^{17}$cm$^{-3}$, is insufficiently sensitive, requires chemical etching of the ingot surfaces, and gives insufficiently localised measurements.

## Disclosure of the Invention

It is an object of this invention to increase the precision and locality control of oxygen distribution in silicon ingots.

The essence of the invention is determining the silicon ingot oxygen concentration by irradiating the ingot with three alternating beams of IR-radiation of different wavelengths, one of which wavelengths lies at the absorption maximum of interstitial oxygen, 5.81 $\mu$m, the other two being outside the absorption band According to the present invention the ingots are exposed to three monochromatic beams of radiation from a three wavelength CO laser with a modulating disk incorporated into the resonator, which disk sequentially switches the generation of each one of the beams on and off. Two ratios of radiation transmission coefficients are then measured, and the required oxygen concentration is determined according to the formula:

$$N = \frac{K}{d} \ln [(T_1/T_2)(T_1/T_3)^I]$$

wherein

$K = 2 \times 10^{19}\,\mathrm{cm}^{-2}$ - calibration coefficient.
$d$ - ingot thickness.

$$I = \frac{\lambda_1 - \lambda_2}{\lambda_3 - \lambda_1}$$

- a coefficient, defined by selection of analytical wavelengths.

$\lambda_1$, $\lambda_3$ - the wavelengths outside the absorption band.

$\lambda_2$ - wavelength corresponding to absorption maximum.

$T_1$, $T_2$, $T_3$ - transmission coefficients at wavelengths $\lambda_1$, $\lambda_2$, $\lambda_3$ respectively.

The claimed technical solution differs from the prior art in that it uses monochromatic beams of radiation, produced by interresonator modulation of generation of a three wavelength CO laser with a rotating modulating disk to determine two ratios of radiation transmission coefficients of the ingot.

## Brief Description of Drawings

Figure 1 shows the variation of the measured absorption coefficient ($\alpha_{meas}$) determined at 5.81 $\mu$m, with interstitial oxygen concentration (N) detected according to the prior art (1) and the proposed method (2).

Figure 2 shows an optical scheme of the three wavelength CO laser with a modulating disk incorporated into the resonator, wherein 1 is a discharge tube, 2 is a non-transmitting mirror, 3 is a defraction grating, 4, 5, 6 are auxiliary mirrors and 7 is a modulating disk.

Figure 3 shows the spectral dependency of background optical density (ln 1/T) for a P-type silicon ingot with a specific resistance of 12 $\Omega$ cm for different types of surface, where 1 - optical polishing, 2 - chemical etching, 3 - lapped diffusing surface.

Figure 4 shows radial oxygen distribution in silicon ingots with 100 mm diameter and 95mm length.

Figure 5 shows an oxygen distribution profile along the axis of growth of an ingot having a diameter of 150mm.

## Preferred Embodiment

The method is as follows.

Three beams of monochromatic radiation of a three wavelength CO laser are alternately passed through the cylindrical ingot being examined, falling parallel or perpendicular to the aids of ingot growth, one of which beams has the wavelength $\lambda_2 = 5.81\mu$m corresponding to the absorption maximum of oxygen, and the other two beams have wavelengths, $\lambda_1$, $\lambda_3$ outside the absorption band in a region of linear spectral dependence of the background optical density of the ingot (Figure 3). The two ratios Of intensity of incident radiation $I_0(\lambda_1)/I_0(\lambda_2)$, $I_0(\lambda_1)/I(\lambda_3)$ and transmitted radiation $I(\lambda_1)/(\lambda_2)$, $I(\lambda_1)/I(\lambda_3)$ are determined by means of two photodetectors, an amplifier, a digitizer and a micro-computer. After that the oxygen concentration being sought in the irradiated part of the ingot is determined according to the formula

$$ N = \frac{K}{d} \ln \left[ (T_1/T_2)\,(T_1/T_3)^r \right] $$

where

$K = 2 \times 10^{19}$ cm$^{-2}$ - is a calibrating coefficient;
d - ingot thickness,

$$ r = \frac{\lambda_1 - \lambda_2}{\lambda_3 - \lambda_1} $$

coefficient defined by selection of analytical wavelengths, and

$$ T_1 = I(\lambda_1)/I_0(\lambda_1) $$
$$ T_2 = I(\lambda_2)/I_0(\lambda_2) $$
$$ T_3 = I(\lambda_3)/I_0(\lambda_3) $$

are radiation transmission coefficients at the three wavelengths $\lambda_1$, $\lambda_2$, $\lambda_3$ respectively.

If equality of incident beam intensity is obtained by means of regulating the diameter of the modulating disk orifices such that $I_0(\lambda_1) = I_0(\lambda_2) = I_0(\lambda_3)$, only the transmitted beam intensities are detected and the second photodetector is no longer necessary.

Another embodiment of this method is based on separation of the laser beams into two parts by means of a separating plate, one of which parts is passed through the crystal having a thickess where the oxygen content is known (the reference crystal). By means of one or two photodetectors, the ratios of intensity of radiation beams transmitted by the crystal being examined $I(\lambda_1)/I(\lambda_2)$, $I(\lambda_1)/I(\lambda_3)$ and reference crystal $I_0(\lambda_1)/I_0(\lambda_2)$, $I_0(\lambda_1)/I_0(\lambda_3)$ may be determined, and according to the foregoing formula the difference in the oxygen concentration in the examined and reference ingots is determined.

The results of this embodiment for determining the longitudinal and lateral distribution of oxygen in industrial silicon ingots are shown in Figure 4 and Figure 5.

## Industrial Application

The present invention, a method of determining the oxygen concentration in silicon crystals, may be widely utilised in electronics and other industries for control of the content and distribution of oxygen in silicon ingots.

The invention may also be used for sorting silicon ingots or parts thereof according to their oxygen content ratios before cutting into industrial wafers, as well as in developing the technology of growing homogeneous silicon ingots.

## Claims

1. A method of determining the concentration of oxygen in silicon crystals, involving alternately passing through the ingot three IR-radiation beams having different wavelengths, one of which wavelengths lies at the absorption maximum of interstitial oxygen at 5.81 $\mu$m, the other two being out of the absorption band. The method is different from the prior art in that the ingots are exposed to three monochromatic radiation beams from a three-wavelength CO laser with a modulating disk incorporated into a resonator, which disk alternately switches each one of the beams on and off. Two ratios of radiation transmission coefficients of the ingot are measured, while the oxygen concentration being sought is determined according to the following formula:

$$ N = \frac{K}{d} \ln \left[ (T_1/T_2)\,(T_1/T_3)^r \right] $$

wherein

$K = 2 \times 10^{19}$ cm$^{-2}$ - is a calibration coefficient,
d - ingot thickness,

$$ r = \frac{\lambda_1 - \lambda_2}{\lambda_3 - \lambda_1} $$

- coefficient, defined by selection of analytical wavelength,

$\lambda_1$, $\lambda_3$ - wavelength outside the absorption band. $\lambda_2$ - wavelength corresponding to maximum absorption band,

$T_1$, $T_2$, $T_3$ - transmission coefficients values at wavelengths $\lambda_1$, $\lambda_2$, $\lambda_3$ respectively.

| INTERNATIONAL SEARCH REPORT | International application No. |
|---|---|
| | PCT/BY 94/00001 |

**A. CLASSIFICATION OF SUBJECT MATTER**

Int.Cl.6   H01L 21/66

According to International Patent Classification (IPC) or to both national classification and IPC

**B. FIELDS SEARCHED**

Minimum documentation searched (classification system followed by classification symbols)

Int.Cl.6   H01L 21/66, H01N21/25, 21/31, G01N21/39

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | US, A, 4429047 (RCA CORPORATION) 31 January 1984 (31.01.84) --- | 1 |
| A | US, A, 4040895 (INTERNATIONAL BUSINESS MACHINES CORPORATION) 9 August 1977 (09.08.77) --- | 1 |
| A | US, A, 4591409 (TEXAS INSTRUMENTS INCORPORATED) 27 May 1986 (27.05.86) --- | 1 |
| A | SU, A, 999128 (INSTITUT FIZIKI POLUPROVODNIKOV SO AN SSSR) 23 February 1983 (23.02.83) --- | 1 |
| A | Ju.R. NOSOV. OPTOELEKTRONIKA 1977, " SOVETSKOE RADIO", (MOSCOW), p. 33-34 --- | 1 |
| A | SBORNIK INFORMATSIONNYKH MATERIALOV. KOORDINATSIONNY TSENTR PO PROBLEME "SOZDANIE NOVYKH POLUPROVODNIKOVYKH MATERIALOV I METALLOV VYSOKOI CHASTOTY". | 1 |

☐ Further documents are listed in the continuation of Box C.       ☐ See patent family annex.

* Special categories of cited documents:

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 12 December 1994 (12.12.94) | 22 December 1994 (22.12.94) |

| Name and mailing address of the ISA/<br>ISA/BY | Authorized officer |
|---|---|
| Facsimile No. | Telephone No. |

Form PCT/ISA/210 (second sheet) (July 1992)

C (Continuation). DOCUMENTS CONSIDERED TO BE RELEVANT

| Category* | Citation of document, with indication, where appropriate, of the relevant passages | Relevant to claim No. |
|---|---|---|
| | VYN. 4, ONYBL. 1977, IZD. SOVETA UPOLNOMOCHENNYKH SRANCHLENOR SEV, (MOSCOW) E.P. RASHEVSKAYA, METOGY OSNOVANNYE NA IZMERENII OTRAZHENYA v IK- OBLASTI VBLIZI POLOS OSTATOCHNYKH LUCHEI I PLAZMENNOGO REZONANSA, P. 163-172<br><br>--- | |